# EUROPEAN PATENT APPLICATION

(11) **EP 1 337 042 A1**
(43) Date of publication of application: **20.08.2003**
(21) Application number: 03250780.8
(22) Date of filing: 07.02.2003
(51) Int. Cl.: H03J 5/24

(54) **Television tuner**

(30) Priority: 14.02.2002 JP 2002037083
(71) Applicant: ALPS ELECTRIC CO., LTD., Ota-ku Tokyo 145 (JP)
(72) Inventor: Maruyama, Takashi, Alps Electric Co., Ltd., Tokyo (JP)
(74) Representative: Kensett, John Hinton

(57) **Abstract**

A tuner for a television set includes an input terminal (1) for receiving television signals and a tuning circuit connected to the input terminal. The tuning circuit includes a first tuning circuit (6) for tuning the television set to channels in a VHF low band, a second tuning circuit (9) for tuning the television set to channels in a VHF high band, and a third tuning circuit (13) for tuning the television set to channels in a UHF band. The tuner for the television set also includes a low-pass filter (4) provided between the input terminal and the first tuning circuit and a high-pass filter provided between the input terminal and the third tuning circuit. The cut-off frequency of the low-pass filter is lower than the VHF high band and the cut-off frequency of the high-pass filter is higher than the VHF high band.

## Description

### BACKGROUND OF THE INVENTION

### 1. Field of the Invention

The present invention relates to a tuner for a television set and, more particularly, to a television tuner including a tuning circuit for tuning a television set to lower-frequency channels in the very high frequency band (hereinafter referred to as the VHF band), a tuning circuit for tuning the television set to higher-frequency channels in the VHF band, and a tuning circuit for tuning the television set to channels in the ultra high frequency band (hereinafter referred to as the UHF band).

### 2. Description of the Related Art

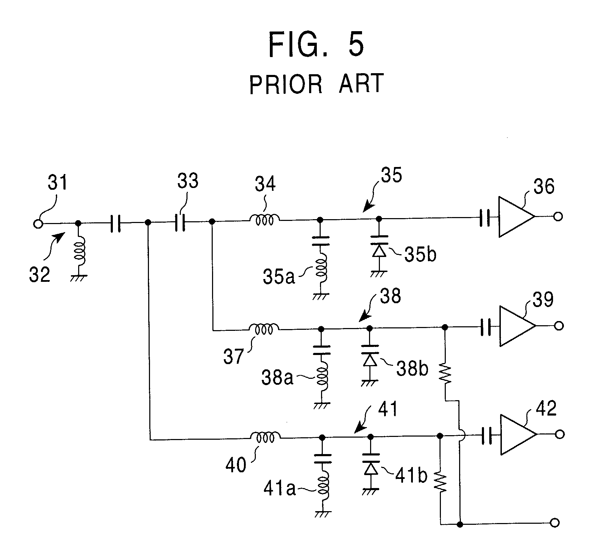

A known tuner for a television set will be described with reference to Fig. 5. Television signals in channels ranging from the VHF band to the UHF band are input to an input terminal 31. The input terminal 31 is connected to an input filter 32. The input filter 32 is connected in series to a DC cut-off and coupling capacitor 33 that is connected in series to a coupling inductance element 34. The coupling inductance element 34 is connected in series to a first tuning circuit 35. The first tuning circuit 35 has an inductance element 35a and a varactor diode 35b and tunes the television set to lower-frequency channels, including the lowest-frequency channel, in the VHF band. The first tuning circuit 35 is connected to a first amplifier circuit 36.

The DC cut-off capacitor 33 is also connected to a coupling inductance element 37 that is connected to a second tuning circuit 38. The second tuning circuit 38 has an inductance element 38a and a varactor diode 38b and tunes the television set to higher-frequency channels, including the highest-frequency channel, in the VHF band. The second tuning circuit 38 is connected to a second amplifier circuit 39.

The input filter 32 is also connected to a coupling inductance element 40 that is connected to a third tuning circuit 41. The third tuning circuit 41 has an inductance element 41a and a varactor diode 41b and tunes the television set to channels in the UHF band. The third tuning circuit 41 is connected to a third amplifier circuit 42.

Each anode of the varactor diodes 35b, 38b, and 41b included in the first, second, and third tuning circuits 35, 38, and 41, respectively, is grounded and a tuning voltage is applied to each cathode thereof. The tuning voltage determines the tuning frequency of each of the tuning circuits 35, 38, and 41.

With the circuit configuration described above, television signals over a wide band from the VHF band to the UHF band are input to the tuning circuits. Since each of the tuning circuits is generally a single tuning circuit, the skirt characteristic curve thereof is not so sharp. Thus, for example, when television signals in a VHF low band are received, television signals in a VHF high band are input to the first amplifier circuit through the first tuning circuit. As a result, the television signals in the VHF low band to be received are disadvantageously prone to interference with the television signals in the VHF high band.

Also, when the television signals in the VHF high band are received, the television signals in the VHF low band and those in the UHF band are input to the second amplifier circuit through the second tuning circuit. As a result, the television signals in the VHF high band to be received are disadvantageously prone to interference with the television signals in the VHF low band or those in the UHF band.

Similarly, when the television signals in the UHF band are received, the television signals in the UHF band to be received are disadvantageously prone to interference with the television signals in the VHF high band.

### SUMMARY OF THE INVENTION

Accordingly, it is an object of the present invention to provide a television tuner that prevents interference of television signals to be received in a VHF low band, a VHF high band, or the UHF band with television signals in other bands.

The present invention provides, in its first aspect, a tuner for a television set, including an input terminal for receiving television signals and a tuning circuit connected to the input terminal. The tuning circuit includes a first tuning circuit for tuning the television set to channels in a VHF low band, a second tuning circuit for tuning the television set to channels in a VHF high band, and a third tuning circuit for tuning the television set to channels in a UHF band. The tuner for the television set also includes a low-pass filter provided between the input terminal and the first tuning circuit and a high-pass filter provided between the input terminal and the third tuning circuit. The cut-off frequency of the low-pass filter is lower than the VHF high band and the cut-off frequency of the high-pass filter is higher than the VHF high band. With such a tuner, since the television signals in the VHF high band input to the first tuning circuit are attenuated, interference with the television signals in the VHF high band when the television signals in the VHF low band are received can be reduced. Additionally, since the television signals in the VHF high band input to the third tuning circuit are attenuated, interference with the television signals in the VHF high band when the television signals in the UHF band are received can be reduced.

The first, second, and third tuning circuits preferably vary their tuning frequencies interdependently within the VHF low band, the VHF high band, and the UHF band, respectively. It is preferable that the cut-off frequency of the low-pass filter be higher than the tuning frequency of the first tuning circuit and the cut-off frequency of the high-pass filter be lower than the tuning frequency of the third tuning circuit. The cut-off frequencies of the low-pass filter and the high-pass filter preferably vary interdependently with the tuning frequencies of the first to third tuning circuits. With such a circuit configuration, the television signals in the VHF high band input to the first tuning circuit and the television signals in the VHF high band input to the third tuning circuit can be effectively attenuated.

The low-pass filter preferably includes a first inductance element connected between the input terminal and the first tuning circuit and a first capacitive element for shunting the connection between the first inductance element and the first tuning circuit to the ground. The high-pass filter preferably includes a second capacitive element connected between the input terminal and the third tuning circuit and a second inductance element for shunting the connection between the second capacitive element and the third tuning circuit to the ground. With such a circuit configuration, when the television signals in the VHF high band are received, the low-pass filter and the high-pass filter serve as trap circuits, thereby attenuating the television signals in the VHF low band and in the UHF band input to the second tuning circuit. Accordingly, interference with the television signals in the VHF low band and those in the UHF band can be reduced.

The first to third tuning circuits preferably have respective varactor diodes for changing the respective tuning frequencies thereof. The first and second capacitive elements preferably are varactor diodes. It is preferable that the same tuning voltage be applied to the varactor diode of each of the tuning circuits, to the varactor diode of the low-pass filter, and to the varactor diode of the high-pass filter. With such a tuner, the tuning frequencies of the tuning circuits and the cut-off frequencies of the high-pass and low-pass filters can interdependently vary.

The above and other objects, features, and advantages of the present invention will become clear from the following description of the preferred embodiments taken in conjunction with the accompanying drawings.

### BRIEF DESCRIPTION OF THE DRAWINGS

Fig. 1 is a circuit diagram showing the configuration of a television tuner according to an embodiment of the present invention;
Fig. 2 is a graph showing the transmission characteristic of a first tuning circuit, at its output, in the television tuner of the present invention;
Fig. 3 is a graph showing the transmission characteristic of a second tuning circuit, at its output, in the television tuner of the present invention;
Fig. 4 is a graph showing the transmission characteristic of a third tuning circuit, at its output, in the television tuner of the present invention; and
Fig. 5 is a circuit diagram showing the configuration of a known television tuner.

### DESCRIPTION OF THE PREFERRED EMBODIMENTS

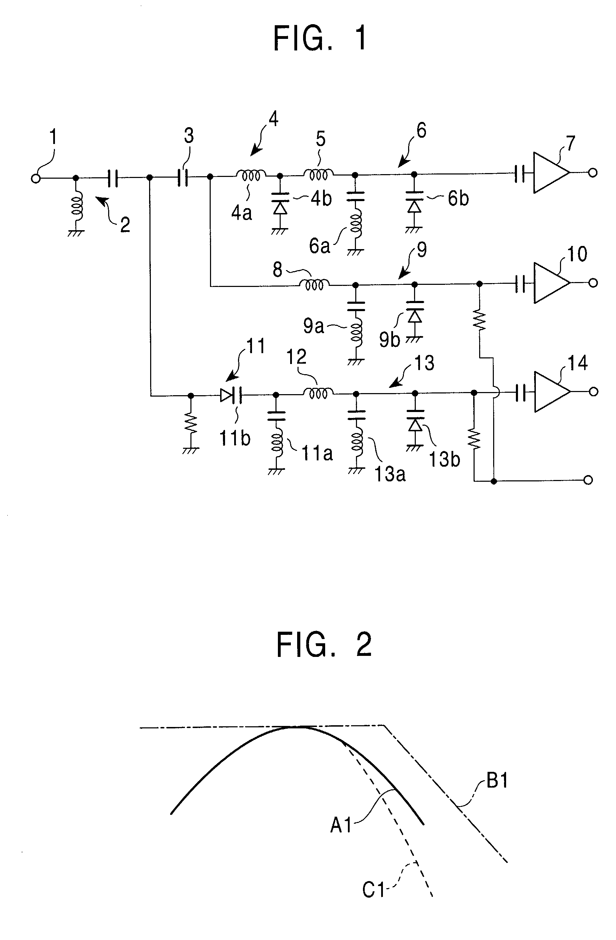

A television tuner according to an embodiment of the present invention will now be described with reference to Figs. 1 to 4.

Referring to Fig. 1, television signals in channels ranging from the VHF band to the UHF band are input to an input terminal 1. The input terminal 1 is connected to an input filter 2. The input filter 2 attenuates television signal components in an intermediate frequency band, but transmits television signal components having a frequency equal to or greater than that of the lowest-frequency channel in the VHF band. The input filter 2 is connected to a DC cut-off and coupling capacitor 3 that is connected to a low-pass filter 4. The low-pass filter 4 has a first inductance element 4a and a first capacitive element 4b. The first capacitive element 4b is a varactor diode, the anode of which is grounded. One end of the first inductance element 4a is connected to the DC cut-off capacitor 3 and the other end is connected to the cathode of the varactor diode.

The low-pass filter 4 is connected to a coupling inductance element 5 that is connected to a first tuning circuit 6. The first tuning circuit 6 is a parallel circuit including an inductance element 6a and a varactor diode 6b and tunes the television set to lower-frequency channels, including the lowest-frequency channel, in the VHF band. The anode of the varactor diode 6b is grounded. The first tuning circuit 6 is connected to a first amplifier circuit 7.

The DC cut-off capacitor 3 is also connected to a coupling inductance element 8 that is connected to a second tuning circuit 9. The second tuning circuit 9 includes an inductance element 9a and a varactor diode 9b and tunes the television set to higher-frequency channels, including the highest-frequency channel, in the VHF band. The second tuning circuit 9 is connected to a second amplifier circuit 10.

The input filter 2 is also connected to a high-pass filter 11 that includes a second inductance element 11a and a second capacitive element 11b. The second capacitive element 11b is a varactor diode, the anode of which is connected to the input filter 2 and is DC-grounded through a resistor. The cathode of the second capacitive element lib is RF-grounded through the second inductance element 11a.

The high-pass filter 11 is connected to a coupling inductance element 12 that is connected to a third tuning circuit 13. The third tuning circuit 13 has an inductance element 13a and a varactor diode 13b and tunes the television set to channels in the UHF band. The third tuning circuit 13 is connected to a third amplifier circuit 14.

A tuning voltage is applied to the cathodes of the varactor diodes 6b, 9b, and 13b included in the first, second, and third tuning circuits 6, 9, and 13, respectively, to the cathode of the varactor diode 4b in the low-pass filter 4, and to the cathode of the varactor diode lib in the high-pass filter 11. Using the tuning voltage, the tuning frequencies of the tuning circuits are synchronized with the frequency of a channel to be received.

The cut-off frequencies of the low-pass filter 4 and the high-pass filter 11 also vary with the tuning voltage. The cut-off frequencies vary interdependently with the tuning frequencies of the tuning circuits 6, 9, and 13. The cut-off frequency of the low-pass filter 4 is set so as to vary within the frequency range between the tuning frequency of the first tuning circuit 6 and a VHF high band. The cut-off frequency of the high-pass filter 11 is set so as to vary within frequency range between the VHF high band and the tuning frequency of the third tuning circuit 13.

With the circuit configuration described above, since the television signals are input to the first tuning circuit 6 through the low-pass filter 4, the television signals in the VHF high band input to the first tuning circuit 6 and the first amplifier circuit 7 are attenuated. In other words, as shown in Fig. 2, at the output of the first tuning circuit 6, the tuning characteristic A1 of the first tuning circuit 6 is combined with the skirt characteristic B1 of the low-pass filter 4 to provide an overall characteristic C1, and therefore the television signals in the VHF high band are significantly attenuated. Accordingly, when the lower-frequency channels in the VHF band are received, interference with the television signals in the VHF high band, such as image interference, is reduced.

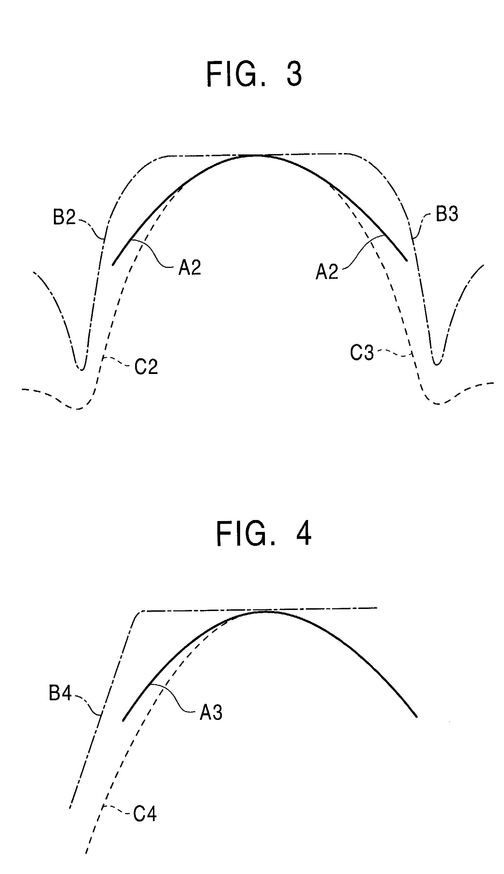

The low-pass filter 4 serves as a series trap circuit for the television signals in the VHF high band input to the second tuning circuit 9 and the trap frequency of the series trap circuit is the same as the cut-off frequency of the low-pass filter 4. Thus, the television signals in a VHF low band input to the second tuning circuit 9 and the second amplifier circuit 10 are attenuated. In other words, as shown in Fig. 3, at the output of the second tuning circuit 9, the tuning characteristic A2 of the second tuning circuit 9 is combined with the trap characteristic B2 of the low-pass filter 4 to provide an overall characteristic C2. Accordingly, when the higher-frequency channels in the VHF band are received, interference with the television signals in the VHF low band, for example, interference with the television signals in the VHF low band having a frequency that is half of the frequency of a higher-frequency channel in the VHF band to be received, is reduced.

The high-pass filter 11 also serves as a series trap circuit for the television signals in the VHF high band input to the second tuning circuit 9 and the trap frequency of the series trap circuit is the same as the cut-off frequency of the high-pass filter 11. Thus, the television signals in the UHF band input to the second tuning circuit 9 and the second amplifier circuit 10 are attenuated. In other words, as shown in Fig. 3, at the output of the second tuning circuit 9, the tuning characteristic A2 of the second tuning circuit 9 is combined with the trap characteristic B3 of the high-pass filter 11 to provide an overall characteristic C3. Accordingly, when the higher-frequency channels in the VHF band are received, interference with the television signals in the UHF band input to the second amplifier circuit 10, such as image interference, is reduced.

Since the television signals are input to the third tuning circuit 13 through the high-pass filter 11, the television signals in VHF high band input to the third tuning circuit 13 and the third amplifier circuit 14 are attenuated. In other words, as shown in Fig. 4, at the output of the third tuning circuit 13, the tuning characteristic A3 of the third tuning circuit 13 is combined with the skirt characteristic B4 of the high-pass filter 11 to provide an overall characteristic C4, and therefore the television signals in the VHF high band are significantly attenuated. Accordingly, when the channels in the UHF band are received, interference with the television signals in the VHF high band is reduced.

## Claims

1. A tuner for a television set, comprising:
an input terminal for receiving television signals;
a tuning circuit connected to the input terminal, the tuning circuit including a first tuning circuit for tuning the television set to channels in a VHF low band, a second tuning circuit for tuning the television set to channels in a VHF high band, and a third tuning circuit for tuning the television set to channels in a UHF band;
a low-pass filter provided between the input terminal and the first tuning circuit; and
a high-pass filter provided between the input terminal and the third tuning circuit,
wherein the cut-off frequency of the low-pass filter is lower than the VHF high band and the cut-off frequency of the high-pass filter is higher than the VHF high band.

2. A tuner for a television set according to Claim 1,
wherein the first, second, and third tuning circuits are capable of interdependently varying their tuning frequencies within the VHF low band, the VHF high band, and the UHF band, respectively,
wherein the cut-off frequency of the low-pass filter is higher than the tuning frequency of the first tuning circuit,
wherein the cut-off frequency of the high-pass filter is lower than the tuning frequency of the third tuning circuit, and
wherein the cut-off frequencies of the low-pass filter and the high-pass filter vary interdependently with the tuning frequencies of the first, second, and third tuning circuits.

3. A tuner for a television set according to Claim 1 or 2,
wherein the low-pass filter includes a first inductance element connected between the input terminal and the first tuning circuit and a first capacitive element for shunting the connection between the first inductance element and the first tuning circuit to the ground, and
wherein the high-pass filter includes a second capacitive element connected between the input terminal and the third tuning circuit and a second inductance element for shunting the connection between the second capacitive element and the third tuning circuit to the ground.

4. A tuner for a television set according to Claim 3,
wherein the first, second, and third tuning circuits have respective varactor diodes for changing the respective tuning frequencies thereof,
wherein the first and second capacitive elements are varactor diodes, and
wherein the same tuning voltage is applied to the varactor diode of each of the tuning circuits, to the varactor diode of the low-pass filter, and to the varactor diode of the high-pass filter.
